# FASCICULE DE BREVET EUROPEEN

(11) **EP 2 599 745 B1**
(45) Date de publication et mention de la délivrance du brevet: **27.09.2017**
(21) Numéro de dépôt: 12194179.3
(22) Date de dépôt: 26.11.2012
(51) Int. Cl.: B81C 1/00

(54) **Procédé de réalisation d'une structure comportant au moins une partie active présentant des zones d'épaisseurs differentes**
Verfahren zum Herstellen eines MEMS Bauteil mit bewegliche Teile unterschiedlicher Dicke
Fabrication of a MEMS device having moving parts of different thicknesses.

(30) Priorité: 30.11.2011 FR 1160973
(43) Date de publication de la demande: 05.06.2013
(73) Titulaire: Commissariat à l'Énergie Atomique et aux Énergies Alternatives, 75015 Paris (FR)
(72) Inventeur: Robert, Philippe, 38000 Grenoble (FR); Giroud, Sophie, 38120 Saint-Egreve (FR)
(74) Mandataire: Ilgart, Jean-Christophe

(56) Documents cités:
- WO-A2-2010/092399
- US-B1- 7 972 888
- PH ROBERT ET AL: "M&NEMS: A new approach for ultra-low cost 3D inertial sensor", SENSORS, 2009 IEEE, IEEE, PISCATAWAY, NJ, USA, 25 octobre 2009 (2009-10-25), pages 963-966, XP031618603, ISBN: 978-1-4244-4548-6

## Description

### DOMAINE TECHNIQUE ET ART ANTÉRIEUR

La présente invention se rapporte à un procédé de réalisation d'une structure comportant au moins une partie active présentant des zones d'épaisseurs différentes. Cette structure peut être mise en oeuvre dans la réalisation de systèmes microélectromécaniques (MEMS ou "microelectromechanical systems" en terminologie anglo-saxonne) et/ou de systèmes nanoélectromécaniques (NEMS ou "nanoelectromechanical systems" en terminologie anglo-saxonne) pour la réalisation par exemple de capteurs ou d'actionneurs.

Les capteurs MEMS et NEMS comportent une partie fixe et au moins une partie suspendue par rapport à la partie fixe, la ou les parties suspendues appelées "parties actives" sont aptes à se déplacer et/ou se déformer sous l'effet d'une action extérieure, telle qu'une action mécanique, électrique, magnétique...

Le déplacement et/ou la déformation de la partie mobile par rapport à la partie fixe permet de déterminer par exemple une accélération dans le cas d'un accéléromètre, une force de Coriolis dans le cas d'un gyromètre. Le déplacement de la partie mobile est par exemple mesuré au moyen de jauge de contrainte.

L'article Ph. Robert, V. Nguyen, S. Hentz, L. Duraffourg, G. Jourdan, J. Arcamone, S. Harrisson, M&NEMS: A new approach for ultra-low cost 3D inertial sensor, IEEE SENSORS 2009 Conference - 25-28 October 2009 - Christchurch New Zealand, (2009*)* décrit une structure MEMS&NEMS formant un accéléromètre dans le plan. La structure comporte une partie active formée de deux épaisseurs actives distinctes : la partie NEMS formant une jauge de contrainte comporte une des épaisseurs actives, et la partie MEMS formant une masse sismique comporte les deux épaisseurs actives.

Le procédé de réalisation d'une telle partie active se fait à partir d'un substrat de type SOI ("Silicon on Insulator") qui a un coût de revient élevé. De plus, une étape de croissance épitaxiale épaisse est mise en oeuvre, une telle étape est généralement longue et coûteuse. La jauge de contrainte est formée à partir du substrat SOI, la masse sismique est formée à partir du substrat SOI et de la couche formée par épitaxie épaisse.

Par ailleurs, l'étape de définition de la partie active met en oeuvre une couche d'oxyde sur laquelle la croissance de semi-conducteur aura en partie lieu. Or, la couche formée par croissance sur la couche d'oxyde n'est pas monocristalline dans les zones d'interface entre les deux épaisseurs, qui étaient protégées par la couche d'oxyde.

Ces zones « poly-cristallines » peuvent générer des défauts dans la structure.

De plus, la vitesse de croissance est différente entre les zones où la croissance se fait sur le silicium monocristallin et les zones où la croissance se fait sur la couche d'oxyde par exemple, qui forme l'interface des deux épaisseurs. Cette différence de vitesse de croissance peut conduire à des inhomogénéités d'épaisseur importante dans la structure finale.

Ce problème d'inhomogénéité de structure dû à la présence de zones polycristallines dans les couches monocristallines et d'inhomogénéité d'épaisseur est d'autant plus problématique dans le cas où l'on souhaite disposer de plus de deux couches distinctes ou de zones d'interface entre deux couches de grande surface.

Il existe des procédés de réalisation de MEMS et/ou NEMS n'utilisant pas de substrat SOI.

Par exemple, le document US 7 494 839 utilise un substrat silicium rendu poreux dans des zones localisées, la membrane du MEMS étant réalisée par épitaxie sur les zones poreuses.

Ce procédé présente l'inconvénient que la structure obtenue ne présente pas d'isolation électrique de la partie active du MEMS. En outre, il requiert également une épitaxie épaisse.

Un autre procédé désigné SCREAM pour *"Single Crystal Reactive Etch and Metallization"* utilise un substrat standard pour réaliser un composant MEMS et utilise une partie enterrée du substrat comme couche sacrificielle. Après la gravure de la structure MEMS dans le substrat, des étapes d'oxydation thermique et de gravure de la couche d'oxyde ont lieu. Le substrat est ensuite gravé pour libérer le MEMS et enfin une métallisation de la structure est réalisée. Ce procédé a un coût de revient réduit, cependant il présente plusieurs inconvénients.

La structure n'a pas d'ancrage isolant.

Cela suppose donc d'avoir des structures MEMS oxydées pour les isoler électriquement et métallisées en surface. Cela provoque la création de contraintes mécaniques importantes sur le MEMS dues à la présence de l'oxyde thermique et du métal sur les structures libérées. Ces contraintes peuvent être très pénalisantes pour le composant final, par exemple elles peuvent générer des dérives en température. En outre, cet ajout d'oxyde et de métal sur le silicium monocristallin rend le composant mécanique moins bon, par exemple dans le cas d'un résonateur le facteur de qualité est moins bon. De plus, la métallisation qui se fait après libération de la structure nécessite l'utilisation d'un masquage mécanique lors du dépôt. Cette méthode est difficilement applicable industriellement, de plus elle donne une résolution des motifs très médiocre.

Ce procédé ne permet pas d'obtenir deux couches actives monocristallines d'épaisseurs différentes et superposées.

Enfin, les structures MEMS se gravant sous le masque d'oxyde lors de la gravure isotrope du silicium, celles-ci sont mal définies.

Il existe enfin un procédé désigné "SON" pour ("Silicon On Nothing" en terminologie anglo-saxonne), consistant à faire croître une couche de SiGe sur un substrat silicium standard, et sur cette couche de SiGe à faire croître une couche de silicium monocristallin. Ce procédé est par exemple décrit dans le document *"Lateral MOSFET transistor with movable gate for NEMS devices compatible with "In-IC" integration", E. Ollier1, & Al.* / *IEEE-NEMS 2007 Conference.* Le composant MEMS/NEMS est réalisé sur cette dernière couche de silicium et le SiGe sert de couche sacrificielle. Pour la libération de la structure mécanique, on utilise une gravure sèche du SiGe à base de CF4, sélective par rapport au silicium monocristallin.

Ce procédé a un coût de revient réduit, cependant il présente lui aussi plusieurs inconvénients. La gravure isotrope du SiGe est assez faiblement sélective par rapport au silicium. Ce procédé est donc limité à des libérations de motifs étroits, typiquement inférieurs au µm.

L'épaisseur de silicium épitaxié sur le SiGe est généralement limitée à quelques centaines de nanomètres. En effet des dislocations risqueraient d'apparaître si l'on souhaitait obtenir de fortes épaisseurs de silicium.

Le SiGe étant semi-conducteur, pour avoir des zones isolées électriquement sur le MEMS/NEMS, une couche isolante doit être prévue dans les zones devant être isolées électriquement. La couche de silicium épitaxiée au-dessus de cette couche isolante sera alors, polycristalline et non monocristalline. Ceci peut être particulièrement préjudiciable pour la tenue mécanique de la structure, puisque ces zones correspondent à des zones d'ancrage où le matériau est particulièrement sollicité. En outre, le fait d'avoir un matériau polycristallin dans ces zones d'ancrage, plutôt que monocristallin, conduit soit à avoir un moins bon facteur de qualité, dans le cas de structure résonante, soit à être plus fragile à des contraintes mécaniques.

### EXPOSÉ DE L'INVENTION

C'est par conséquent un but de la présente invention d'offrir un procédé de réalisation d'une structure comportant une partie active comportant au moins deux zones d'épaisseurs différentes, au moins l'une de ces zones étant en un matériau semi-conducteur monocristallin, ledit procédé étant de coût réduit et ne présentant pas les inconvénients mentionnés ci-dessus.

Le but de la présente invention est atteint par un procédé de réalisation d'une structure munie d'une partie active à plusieurs épaisseurs, comportant, à partir d'un premier substrat formé au moins en face avant d'une couche de matériau semi-conducteur monocristallin, une étape d'usinage, dans ladite couche en face avant, des contours d'une première zone suspendue d'une première épaisseur, une étape de réalisation d'une couche d'arrêt de gravure entre la première zone suspendue et la face arrière du premier substrat, une étape de dépôt d'un matériau sacrificiel et une étape d'usinage à partir de la face arrière du premier substrat pour réaliser une deuxième zone suspendue d'une deuxième épaisseur et une étape de libération des première et deuxième zones suspendues par retrait dudit matériau sacrificiel.

Grâce à l'invention, il n'est pas recouru à un substrat SOI, le coût de fabrication d'une telle structure est donc réduit par rapport à un procédé utilisant un substrat SOI.

En outre le procédé ne nécessite pas d'épitaxie épaisse, il en résulte un gain en coût de fabrication et en temps. En outre, puisque les inhomogénéités d'épaisseur sont réduites, il n'est pas nécessaire d'avoir une étape de polissage mécano-chimique importante pour rattraper les différences d'épaisseur.

Il est possible de fonctionnaliser la couche sacrificielle pour former par exemple des électrodes, un plan de masse relié à la couche MEMS ou des butées anti-collage.

Grâce à l'invention, il est également possible de faire une co-intégration CMOS en trois dimensions.

La présente invention a alors pour objet un procédé de réalisation d'une structure comportant une partie active comportant au moins une première zone suspendue et une deuxième zone suspendue d'épaisseurs différentes à partir d'un premier substrat comportant une première face en matériau semi-conducteur monocristallin, dite face avant, et une deuxième face opposée à la première face, dite face arrière, ledit procédé comportant les étapes :
a) usinage de la face avant du premier substrat pour définir les contours latéraux d'au moins une première zone suspendue en matériau semi-conducteur monocristallin suivant une première épaisseur inférieure à celle du premier substrat, et passivation desdits contours latéraux,
b) formation d'une couche d'arrêt de gravure de la première zone suspendue entre ladite première zone suspendue et la face arrière ;
c) formation sur la face avant du premier substrat d'une couche sacrificielle sélective à la gravure par rapport au matériau semi-conducteur du premier substrat ;
d) usinage à partir de la face arrière du premier substrat jusqu'à dégager certaines zones de ladite couche sacrificielle pour réaliser au moins une deuxième zone suspendue et pour permettre d'atteindre la couche d'arrêt de la première zone suspendue,
e) libération des première et deuxième zones suspendues.

Le premier substrat peut être massif (ou bulk) dans ce cas il est entièrement en matériau semi-conducteur monocristallin. Dans une variante, il peut-être multicouches, au moins la couche dont une face correspond à la face avant du substrat, est alors en matériau semi-conducteur monocristallin

L'étape d) d'usinage pour permettre de réaliser la deuxième zone suspendue et pour d'usinage pour atteindre la couche d'arrêt peut être obtenue par usinage simultané ou par usinages successifs.

La passivation des contours latéraux est réalisée par exemple par le dépôt d'une couche de passivation sur lesdits contours ou une oxydation thermique desdits contours.

De manière très avantageuse, la face arrière du premier substrat étant matériau semi-conducteur monocristallin, la deuxième zone suspendue est en matériau semi-conducteur monocristallin

Dans un premier mode de réalisation, entre l'étape a) et l'étape b), une étape de gravure isotropique a lieu pour retirer une portion de matériau semi-conducteur située entre la première zone suspendue et la face arrière, de sorte à dégager une cavité destinée à recevoir la couche d'arrêt. Le matériau semi-conducteur peut-être polycristallin, il est de préférence monocristallin.

Dans un deuxième mode de réalisation, lors de l'étape b), la couche d'arrêt est formée par oxydation thermique pour transformer une portion de matériau semi-conducteur située entre la première zone suspendue et la face arrière, et former ladite couche d'arrêt.

La couche d'arrêt peut être formée par une oxydation thermique, et/ou par un dépôt d'oxyde.

Par exemple, la couche d'arrêt a une épaisseur comprise entre 0,1 µm et 2 µm.

La formation de la couche sacrificielle peut être réalisée par un dépôt d'oxyde.

Dans un exemple de réalisation, l'étape b) et l'étape c) sont confondues.

L'étape d) peut être réalisée par une gravure, du type gravure profonde par ions réactifs.

La libération de l'étape e) peut être réalisée par exemple avec de l'acide fluorhydrique.

Le premier substrat peut comporter un empilement d'une couche de SiGe monocristallin recouverte d'une couche de silicium monocristallin, la face avant étant en silicium monocristallin et l'étape a) étant telle que la première zone suspendue comporte une couche de silicium monocristallin et une couche de SiGe monocristallin.

Avantageusement, préalablement à l'étape b), au moins la couche de SiGe de la zone suspendue est retirée.

On peut prévoir que le procédé comporte, entre l'étape c) et avant l'étape d), une étape c') de scellement ou de dépôt d'un deuxième substrat en face avant du premier substrat. Le procédé peut alors comporter, préalablement à l'étape c'), une étape de structuration du deuxième substrat.

Lors de l'étape de structuration, une face avant du deuxième substrat est gravée de sorte à réaliser des motifs pour la deuxième zone suspendue et un dépôt est effectué sur ladite face structurée d'une couche destinée à former une couche de scellement lors de l'étape de scellement du deuxième substrat. Ces motifs sont par exemple destinés à former des butées mécaniques.

Le scellement des premier et deuxième substrats est obtenu par exemple par scellement direct ou scellement eutectique.

Le procédé peut comporter, suite à l'étape c), l'étape de structuration de la couche sacrificielle et/ou de dépôt d'une ou de plusieurs couches intermédiaires sur ladite couche sacrificielle, lesdites couches intermédiaires pouvant être structurées.

Par exemple, les structurations de la couche sacrificielle et de la ou des couches intermédiaires sont réalisées par lithographie et gravure respectivement de la couche sacrificielle avec arrêt sur le substrat et de la ou des couches intermédiaires avec arrêt sur la couche sacrificielle.

Il peut être prévu une étape de dépôt d'une couche d'oxyde sur la couche sacrificielle structurée et/ou la ou les couches intermédiaires et une étape de planarisation de la couche d'oxyde, ladite couche d'oxyde participant au scellement.

On peut prévoir également que le premier substrat soit structuré avant l'étape a).

Les étapes a) à b) peuvent être répétées afin de réaliser une partie active ayant plus de deux couches.

Le matériau semi-conducteur de la face avant du premier substrat est avantageusement du silicium monocristallin.

Le procédé selon l'invention permet par exemple la réalisation de de structures microélectro-mécaniques et/ou nanoélectromécaniques pour réaliser des capteurs et/ou des actionneurs.

Le capteur peut être un capteur de pression comportant au moins une membrane déformable suspendue sur un substrat, une des faces de la membrane étant destinée à être soumise à la pression à mesurer, des moyens de détection de la déformation de la membrane formés par au moins une jauge de contraintes, la ou lesdites jauges étant formées par la ou les premières zones suspendues, lesdits moyens de détection étant réalisés à partir du substrat et des moyens de transmission de la déformation de la membrane aux moyens de détection, lesdits moyens de transmission comportant un bras longitudinal articulé en rotation sur le substrat autour d'un axe sensiblement parallèle au plan de la membrane et étant solidaire au moins partiellement de la membrane de sorte qu'il transmette aux moyens de détection, de manière amplifiée, la déformation ou la contrainte issue de la déformation de la membrane, ledit bras longitudinal étant formé par la deuxième zone suspendue, lesdits moyens de transmission étant réalisés à partir du substrat.

### BRÈVE DESCRIPTION DES DESSINS

La présente invention sera mieux comprise à l'aide de la description qui va suivre et des dessins en annexes sur lesquels :
- les figures 1A à 1J sont des représentations schématiques de différentes étapes d'un exemple de procédé de réalisation d'un partie active multi-épaisseurs selon un premier mode de réalisation ;
- les figures 2A à 2E sont des représentations schématiques de différentes étapes de réalisation d'un autre exemple du procédé selon le premier mode de réalisation ;
- les figures 3A à 3E sont des représentations schématiques de différentes étapes de réalisation d'une variante du procédé des figures 2A à 2E ;
- les figures 4A à 4E sont des représentations schématiques de différentes étapes de réalisation d'un exemple du procédé selon un deuxième mode de réalisation ;
- les figures 5A à 5C sont des représentations schématiques des premières étapes de réalisation d'une variante du procédé selon le premier ou le deuxième mode de réalisation, dans laquelle le premier substrat est préalablement usiné ;
- les figures 6A et 6B sont des représentations schématiques d'étapes de réalisation d'une autre variante du procédé selon le premier ou le deuxième mode de réalisation, dans laquelle le deuxième substrat est préalablement usiné ;
- les figures 7A à 7E sont des représentations schématiques d'étapes de réalisation d'une autre variante du procédé selon le premier ou le deuxième mode de réalisation, dans laquelle la couche sacrificielle et des couches intermédiaires sont structurées ;
- les figures 8A et 8B sont des vues de dessus et en coupe longitudinale respectivement d'un capteur de pression pouvant être réalisé grâce au procédé selon l'invention.

### EXPOSÉ DÉTAILLÉ DE MODES DE RÉALISATION PARTICULIERS

Dans la présente demande, on désigne par "partie active" d'une structure MEMS et/ou NEMS une partie suspendue, susceptible de se déplacer et/ou se déformer sous l'effet d'une action extérieure (mécanique, électrique, magnétique,...). La zone qui sera désignée "première zone suspendue" peut former une partie NEMS d'une structure MEMS&NEMS, et la zone qui sera désignée "deuxième zone suspendue" peut former une partie MEMS d'une structure MEMS&NEMS.

Dans la description qui va suivre et à des fins de simplicité, l'exemple du silicium sera utilisé comme matériau semi-conducteur. Il est à noter que la mise en oeuvre de tout autre matériau semi-conducteur ne sort pas du cadre de la présente invention.

Dans les procédés décrits, seules une première zone suspendue et une deuxième zone suspendue sont formées à des fins de simplicité, cependant les procédés selon l'invention permettent de réaliser un ou plusieurs premières zones suspendues et une ou plusieurs deuxièmes zones suspendues.

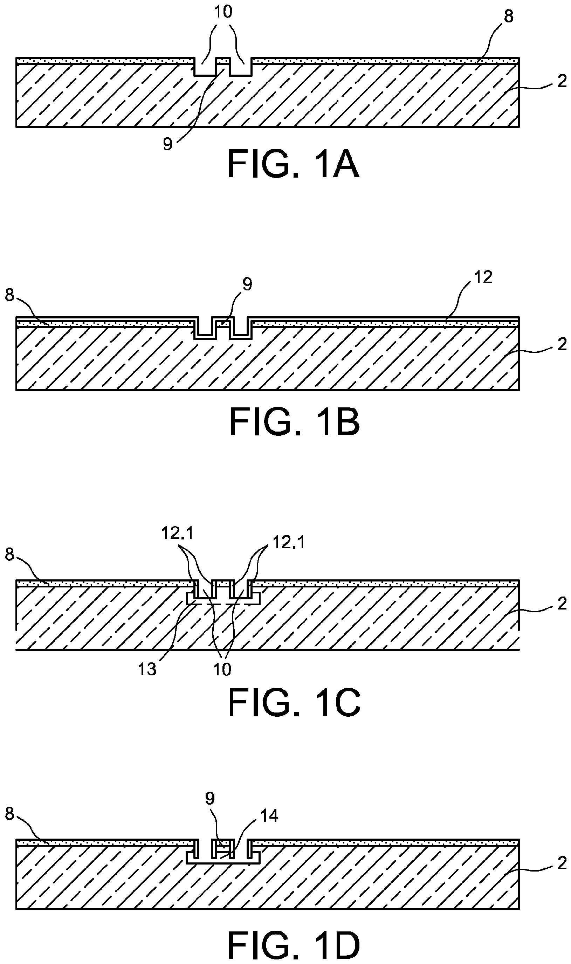

Sur les figures 1A à 1J, on peut voir les étapes d'un exemple d'un premier mode de réalisation d'un procédé de réalisation selon la présente invention d'une structure comportant une partie active munie de zones d'épaisseurs différentes.

Le procédé selon le premier mode de réalisation comporte les étapes principales suivantes à partir d'un premier substrat silicium de type bulk :
a1) usinage de la face avant du premier substrat pour définir une première zone suspendue suivant une première épaisseur,
b1) formation d'une couche d'arrêt de gravure de la première zone suspendue entre ladite zone suspendue et la face arrière, pour cela une étape préalable de retrait du matériau semi-conducteur disposé sous la première zone suspendue a lieu de sorte à former une cavité autour et sous la première zone suspendue ;
c1) dépôt d'une couche sacrificielle sélective à la gravure par rapport au silicium, et plus généralement par rapport au matériau semi-conducteur du premier substrat ;
d1) usinage à partir de la face arrière du premier substrat jusqu'à dégager certaines zones de ladite couche sacrificielle pour réaliser au moins une deuxième zone suspendue et/ou pour permettre d'atteindre la couche d'arrêt de la première zone suspendue,
e1) libération des première et deuxième zones suspendues.

De manière avantageuse, entre l'étape c1) et l'étape d1), on prévoit l'étape c1') de report ou le dépôt d'un support en face avant du premier substrat

Les étapes a1) à e1) du procédé vont maintenant être décrites en détail.

Dans l'exemple représenté sur les figures 1A à 1J, le procédé utilise un premier substrat 2 en silicium monocristallin. Le premier substrat 2 comporte une face avant 4 et une face arrière 6.

Lors de la première étape a1), on effectue un dépôt d'une couche d'oxyde 8, par exemple du SiO₂, sur la face avant 4 du substrat 2, d'environ 0,6 µm d'épaisseur.

On effectue ensuite une étape de lithographie sur la couche 6 par dépôt d'une couche de résine, pour délimiter une première zone suspendue, destinée par exemple à former la première zone suspendue 9. Par exemple, on souhaite réaliser une jauge (de type poutre suspendue) de largeur comprise par exemple entre 0,2 µm et 1 µm de large, d'épaisseur comprise par exemple entre 0,2 µm et 1 µm et une longueur comprise entre 5 µm et 100 µm.

Ensuite, on grave la couche 8 avec arrêt sur le silicium de la face avant 4.

Dans l'exemple représenté deux cavités 10 sont formées de part et d'autre la première zone suspendue 9.

La face avant 4 est ensuite gravée sur une profondeur comprise entre 0,4 µm et 1 µm qui correspond à l'épaisseur souhaitée de la jauge avec une sur-gravure de typiquement 0,1 µm à quelques µm de profondeur par exemple. Il s'agit par exemple d'une gravure avec arrêt au temps.

La couche 8 est gravée par exemple par une gravure chimique ou par gravure par ions réactifs (RIE, "reactive-ion etching" en anglais) et la face avant 2 est gravée par une gravure RIE ou du type gravure profonde par ions réactifs ou DRIE ("deep reactive-ion etching" en anglais).

Enfin on retire la couche de résine.

L'élément ainsi obtenu est représenté sur la figure 1A.

Lors de la deuxième étape b1), on cherche à éliminer le silicium situé sous la jauge dans la représentation de la figure 1A.

Pour cela, un effectue un dépôt d'une couche de passivation 12 conforme d'épaisseur de l'ordre de 0,3 µm par exemple, afin de protéger les bords latéraux ou flancs de la première zone suspendue.

Le matériau de cette couche est choisi de sorte à être sélectif par rapport à la gravure isotrope du silicium qui sera décrite par la suite. Il peut s'agir par exemple du SiO₂ du nitrure ou d'un dépôt de type ALD (Al₂O₃, HfO₂) ("Atomic Layer Déposition" en terminologie anglo-saxonne), dont l'épaisseur est de l'ordre de quelques nanomètres. La couche de passivation 12 recouvre le fond et les bords des cavités 10 ainsi que la couche 8.

L'élément ainsi obtenu est représenté sur la figure 1B.

On effectue ensuite une gravure de la couche de passivation 12 pour découvrir le silicium dans le fond des cavités 10. De préférence, la gravure a lieu sur 0,5 µm de profondeur pour être sûr de dégager le fond des cavités. La gravure est par exemple une gravure au temps avec arrêt sur la couche d'oxyde 8.

L'élément ainsi obtenu est représenté sur la figure 1C. Seules subsistent de la couche de passivation 12 des portions 12.1 sur les flancs des cavités.

Ensuite, selon le premier mode de réalisation, on effectue une gravure isotrope pour libérer la première zone suspendue. Il s'agit d'une gravure au temps. Par exemple, il s'agit d'une gravure gravure RIE ou d'une gravure chimique.

La portion de silicium 13 située sous la première zone suspendue est alors gravée. Du fait de la présence des portions 12.1 de la couche de passivation, les flancs de la première zone suspendue ont été protégés. Il est à noter que les flancs ont néanmoins pu être attaqués partiellement par le dessous de la zone suspendue.

L'élément ainsi obtenu est représenté sur la figure 1D. Une cavité 14 est alors formée sous et autour de la première zone suspendue.

Lors de l'étape c1), on effectue un dépôt d'une couche destinée à protéger la première zone suspendue de la gravure du silicium lors de l'étape d1). Cette couche, désignée couche d'arrêt 15, est formée au moins dans le fond de la cavité 14.

Préalablement à ce dépôt, on effectue de préférence le retrait de la couche d'oxyde 8 et des portions de passivation 12.1. Le retrait de la couche d'oxyde 8 est obtenu par gravure humide ou gravure RIE.

La couche d'arrêt 15 présente une épaisseur suffisante pour protéger la première zone suspendue 9 de la gravure de l'étape d1), celle-ci est par exemple comprise entre 0,1 µm et 1 µm.

La formation de la couche d'arrêt 15 peut être obtenue par une étape d'oxydation thermique. On prévoit une oxydation d'épaisseur limitée pour ne pas consommer trop de matière de la jauge. On fait typiquement une oxydation sur une épaisseur de 50 nm à 200 nm. Cette consommation de silicium peut être prise en compte lors de la gravure de la jauge dans le choix des dimensions initiales (largeur, profondeur) de la jauge. Cette oxydation a pour avantage de supprimer les rugosités sur les flancs latéraux de la première zone suspendue 9 et d'assurer une protection tout autour de la jauge.

Alternativement, la couche d'arrêt 15 peut être obtenue par le dépôt de SiO₂.

Le dépôt de SiO₂ peut boucher entièrement ou partiellement la cavité 14.

Dans une variante particulièrement avantageuse, on effectue préalablement au dépôt de la couche d'oxyde, une oxydation thermique, ce qui assure que la face inférieure de la première zone suspendue est effectivement recouverte d'une couche d'arrêt.

On réalise ensuite ou simultanément le dépôt de la couche sacrificielle 16 sur la face avant du substrat. Le matériau de la couche 16 est sélectif par rapport au silicium pour l'étape de gravure du MEMS et l'étape de libération. La couche sacrificielle 16 peut être formée lors du bouchage de la cavité 14, ou lors d'une étape suivante.

On cherche à maitriser l'épaisseur de la couche sacrificielle. Par exemple, celle-ci sera de l'ordre de 1 µm.

Si la cavité 14 n'est bouchée que partiellement, des creux apparaîtront au droit de la cavité 14 sur la face avant. Il y a alors un contact imparfait lors du scellement avec le deuxième substrat cependant cette zone devant être libérée par la suite, ceci n'est pas gênant pour le fonctionnement du dispositif.

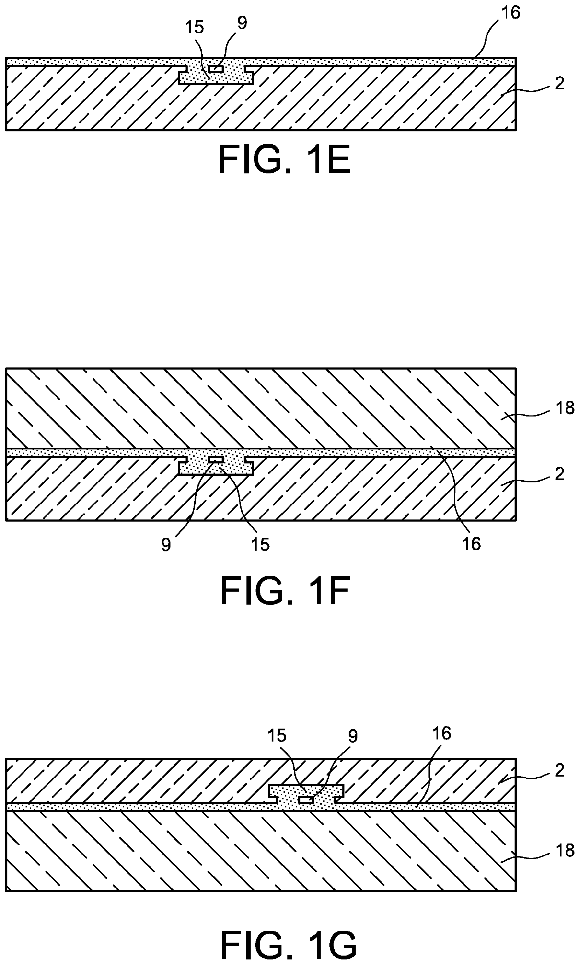

L'élément ainsi obtenu est représenté sur la figure 1E.

Une étape de planarisation de la couche d'oxyde 16 peut avoir lieu dans le cas où la topologie ou la rugosité de la surface obtenue après dépôt de la couche 14 est trop importante. Cette planarisation est par exemple réalisée par polissage mécano-chimique.

Cette étape de planarisation peut être mise en oeuvre lorsqu'on cherche à combler complètement la cavité 14, la couche sacrificielle ainsi formée peut alors présenter une épaisseur trop grande, on effectue alors un amincissement de la couche sacrificielle.

Alternativement, on pourrait envisager de conserver la couche d'oxyde 8 pour former la couche sacrificielle et uniquement former une couche d'arrêt 15 au moins dans le fond de la cavité 14.

Lors de l'étape c1'), un deuxième substrat 18 est scellé sur la couche 16. Le deuxième substrat 18 peut être du type bulk par exemple en silicium monocristallin, verre,... ou CMOS ou pré-processée. La couche sacrificielle 16 est alors disposée entre le premier substrat 2 et le deuxième substrat 18.

L'assemblage est réalisé, dans l'exemple représenté sur la figure 1F par scellement direct (ou SDB pour « Silicon Direct Bonding » en terminologie anglo-saxonne) qui est une technique bien connue de l'homme du métier. Le scellement pourrait également être réalisé par scellement eutectique, ou polymère... le deuxième substrat forme un support, on pourrait par exemple envisager qu'il soit en Pyrex^{®}. Dans ce cas la couche d'interface 16 est par exemple composé d'un multicouche type SiO₂/SiN pour permettre la libération du MEMS sans graver le substrat le support en Pyrex^{®}. L'élément ainsi obtenu est représenté sur la figure 1F.

On retourne ensuite l'assemblage ainsi formé et on peut alors éventuellement effectuer un amincissement du premier substrat 2 à partir de sa face arrière 6. On amincit à une épaisseur de quelques microns à quelques centaines de microns, par exemple à 25 µm. L'amincissement est par exemple réalisé par abrasion en face arrière ou "back-grinding", puis polissage mécano-chimique.

Cet amincissement permet de définir l'épaisseur de la partie MEMS dans le cas de structures dites MEMS&NEMS.

L'élément ainsi obtenu est représenté sur la figure 1G.

Lors d'une étape suivante, on effectue un dépôt d'une couche métallique en vue de réaliser les contacts électrique 20, en face arrière du premier substrat 2, qui forme la face avant de l'élément obtenu par le scellement des premier et deuxième substrats. Pour cela, une étape de lithographie puis une étape de gravure sont réalisées.

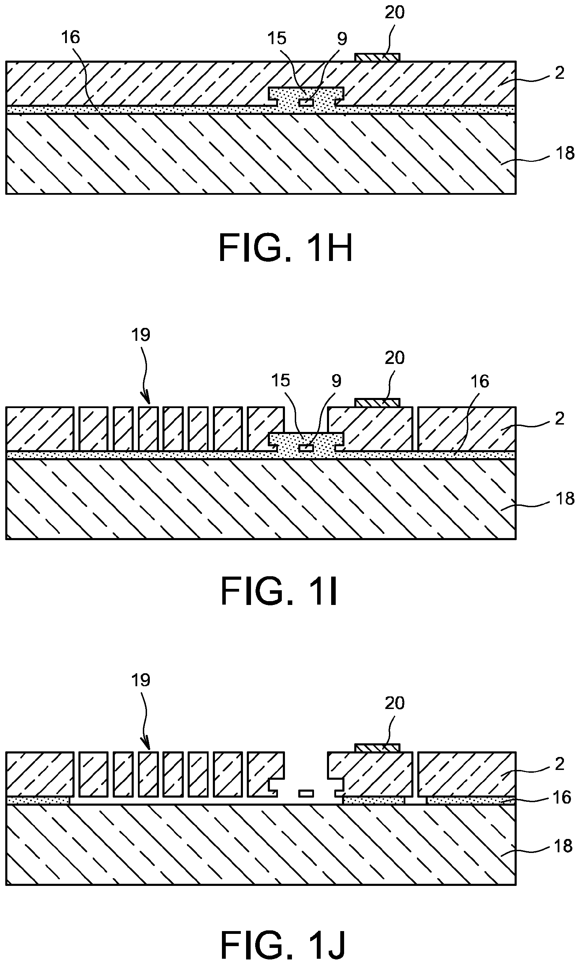

L'élément ainsi obtenu est représenté sur la figure 1H.

Lors de l'étape d), ont lieu une lithographie et une gravure DRIE par exemple, du premier substrat 2 de sorte à dégager certaines zones de la couche sacrificielle 16 pour réaliser la deuxième zone suspendue 19, et à atteindre la couche d'arrêt 15 entre le fond de la cavité 14 et la première zone suspendue 9. L'épaisseur de la couche d'arrêt 15 est telle qu'elle protège la première zone suspendue de la gravure profonde.

L'élément ainsi obtenu est représenté sur la figure 1I.

Enfin, lors d'une étape e1), on libère les première et deuxièmes zones suspendues par exemple par une gravure humide ou en phase vapeur de la couche sacrificielle 16 entre les deux substrats et de la couche d'arrêt 15, à l'acide fluorhydrique. Il s'agit d'une gravure au temps.

L'élément ainsi obtenu est représenté sur la figure 1J.

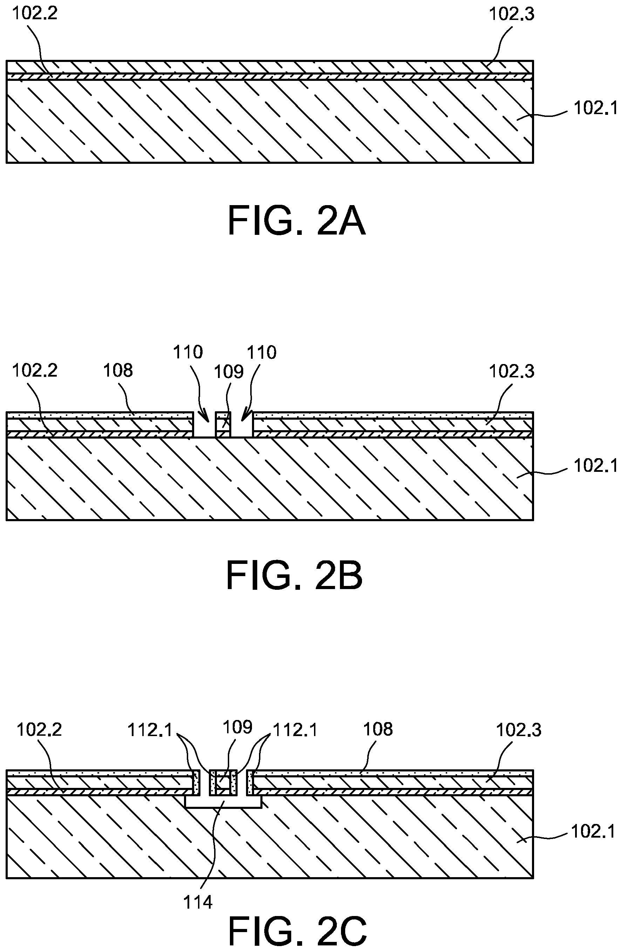

Sur les figures 2A à 2D, on peut voir un autre exemple de réalisation d'un procédé selon le premier mode de réalisation, dans lequel le premier substrat 102 est formé de plusieurs couches.

Lors d'une étape préalable à l'étape a1), une couche de SiGe monocristallin 102.2 est formée sur un substrat en silicium monocristallin 102.1, par exemple par croissance épitaxiale, par exemple d'une épaisseur de 30 nm.

Ensuite, une couche de silicium monocristallin 102.3 est formée sur la couche de SiGe 102.2, par exemple par croissance épitaxiale, par exemple d'une épaisseur comprise entre 10 nm et quelques micromètres, par exemple 250 nm. La face libre de la couche 102.3 forme la face avant du premier substrat 102.

L'élément ainsi obtenu est représenté sur la figure 2A

Lors de l'étape a1), on effectue un dépôt d'une couche de SiO₂ 108 sur la couche 102.3 du substrat 102, par exemple d'environ 0,6 µm d'épaisseur.

On effectue ensuite une étape de lithographie sur la couche 108 par dépôt d'une couche de résine, pour délimiter une première zone suspendue 109. Par exemple, on souhaite réaliser une jauge d'épaisseur comprise entre 0,2 µm et 1 µm et une longueur comprise entre 3 µm et 100 µm.

Ensuite, on grave la couche 108 avec arrêt sur le silicium de la face avant. La face avant est ensuite gravée sur une profondeur comprise entre 0,3 µm et quelques µm, qui correspond à l'épaisseur souhaitée de la première zone suspendue plus une sur-gravure de 100 nm à quelques µm. Ensuite la couche de SiGe 102.2 est également gravée. Il s'agit par exemple de gravures avec arrêt au temps. Les deux gravures sont successives, par exemple de type RIE.

Dans l'exemple représenté deux cavités 110 sont formées de part et d'autre la première partie suspendue 109. Ainsi la partie gravée est formée d'une portion de la couche de Si 102.3 et d'une portion 102.2 de SiGe.

Enfin on retire la couche de résine.

L'élément ainsi obtenu est représenté sur la figure 2B.

On effectue ensuite des étapes similaires à celles représentées sur les figures 1B et 1C, elles ne seront donc pas décrites en détail.

Lors d'une étape suivante, la première zone suspendue 109, est libérée par gravure isotrope de silicium sélective par rapport au SiGe et à la couche de passivation 108.1 qui recouvre les bords latéraux de la première zone suspendue. Il s'agit d'une gravure avec arrêt au temps. Par exemple, il s'agit d'une gravure RIE à base par exemple de gaz fluoré, ou d'une gravure humide.

L'élément ainsi obtenu est représenté sur la figure 2C.

Une cavité 114 est alors formée sous et autour de la première zone suspendue.

Les portions de passivation 108.1 peuvent être retirées, par exemple par gravure humide.

On peut également retirer la portion de SiGe située sous la première zone suspendue 109, par exemple par gravure humide par rapport au silicium. Le retrait de la portion de SiGe a pour effet de limiter les contraintes mécaniques dans la poutre 109.

Lors d'une étape suivante, on effectue un dépôt d'une couche d'arrêt 115 de la gravure du silicium au moins dans le fond de la cavité 114.

Préalablement au dépôt de la couche d'arrêt 115, les portions de passivation 112.1 et la couche d'oxyde 8 sont de préférence retirées.

La couche d'arrêt 115 est formée d'une manière similaire à celle décrite en relation avec la figure 1E.

Une étape de planarisation de la couche d'oxyde 116 peut avoir lieu.

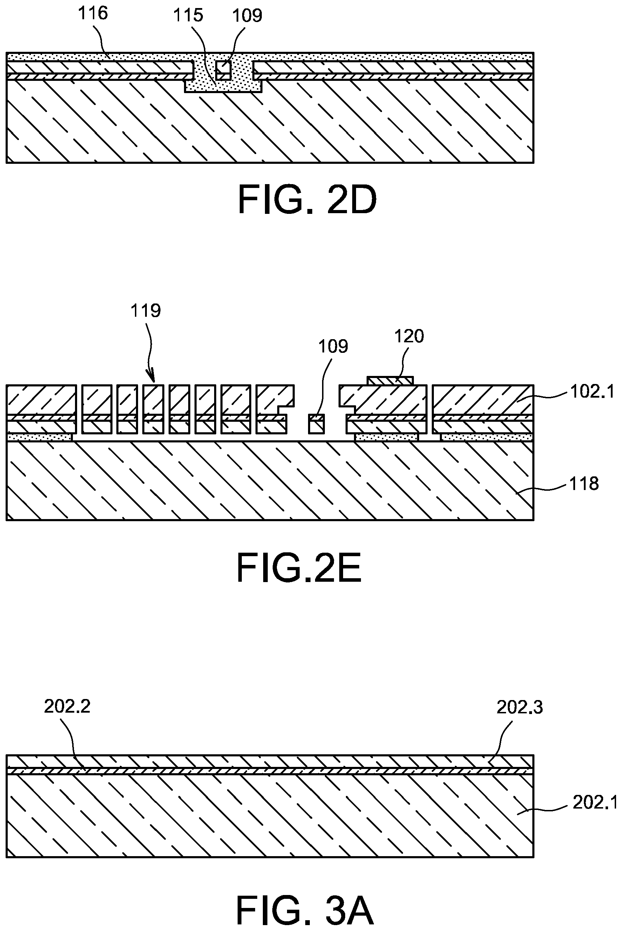

L'élément ainsi obtenu est représenté sur la figure 2D.

On effectue ensuite des étapes similaires à celles représentées sur les figures 1F et 1J, elles ne seront donc pas décrites en détail. En particulier le premier substrat 102 représenté sur la figure 2D est scellé avec un deuxième substrat 118 en face avant, et des contacts 120 sont réalisés en face arrière du premier substrat 102. Un amincissement du substrat 102 peut être réalisé préalablement au scellement.

Lors de l'étape suivante, ont lieu une lithographie et une gravure, du type gravure profonde par ions réactifs ou DRIE ("deep reactive-ion etching" en anglais) du premier substrat 2 de sorte à dégager certaines zones de la couche sacrificielle 116 pour réaliser la deuxième zone suspendue 119, et à atteindre la couche d'arrêt 115 entre le fond de la cavité 114 et la première zone suspendue 109. L'épaisseur de la couche d'arrêt 115 est telle qu'elle protège la première zone suspendue 109 de la gravure profonde.

L'élément ainsi obtenu est représenté sur la figure 2E, la portion de SiGe n'ayant pas été retiré, la première zone suspendue 109 comporte alors deux couches de semi-conducteurs différents, et la deuxième zone suspendue comporte trois couches, deux couches en silicium séparées par une couche de SiGe.

Comme cela a déjà été mentionné, de manière avantageuse, les couches épitaxiées de SiGe et silicium au niveau de la deuxième zone suspendue 119 peuvent être retirées, ce qui permet d'éviter les contraintes mécaniques dues à la présence du SiGe dans les zones libérées. Ce retrait peut être obtenu en procédant à une gravure de cet empilement préalablement à l'étape de scellement avec le deuxième substrat 118 et avant le dépôt de la couche sacrificielle 116.

En outre, la couche épitaxiée de SiGe 102.2 peut avantageusement être retirée au-dessus de la première zone suspendue 109, ce qui permet d'éviter les contraintes mécaniques dues à la présence du SiGe, par exemple par une gravure sèche du SiGe, qui est sélective par rapport au silicium. Cette étape peut avoir lieu après libération des première et deuxième zones suspendues.

Sur les figures 3A à 3E, on peut voir une variante du procédé des figures 2A à 2D, dans laquelle la libération de la première zone suspendue est obtenue par retrait de la couche de SiGe.

Lors d'une étape préalable à l'étape a1), une couche de SiGe monocristallin 202.2 est formée sur un substrat en silicium monocristallin 202.1, par exemple par croissance épitaxiale, par exemple d'une épaisseur de 100 nm. Ensuite, une couche de silicium monocristallin 202.3 est formée sur la couche de SiGe 202.2, par exemple par croissance épitaxiale, par exemple d'une épaisseur comprise entre 10 nm et quelques µm, par exemple 250 nm. La face libre de la couche 202.3 forme la face avant du premier substrat 102.

Lors de l'étape a1), on effectue un dépôt d'une couche de SiO₂ 208 sur la couche 202.3 du substrat 202, par exemple d'environ 0,6 µm d'épaisseur.

On effectue ensuite une étape de lithographie sur la couche 208 par dépôt d'une couche de résine, pour délimiter une première zone suspendue, destinée par exemple à former la première zone suspendue. Par exemple, on souhaite réaliser une jauge d'épaisseur comprise entre 0,2 µm et 1 µm et une longueur comprise entre 3 µm et 100 µm.

Ensuite, on grave la couche 208 avec arrêt sur le silicium 202.3 de la face avant. La face avant est ensuite gravée avec arrêt sur la couche de SiGe 202.2. Il s'agit par exemple de gravures avec arrêt au temps.

Dans l'exemple représenté deux cavités 210 sont formées délimitant la première zone suspendue 209.

Ainsi la partie gravée est formée d'une portion de la couche de silicium 102.3 uniquement.

Enfin on retire la couche de résine.

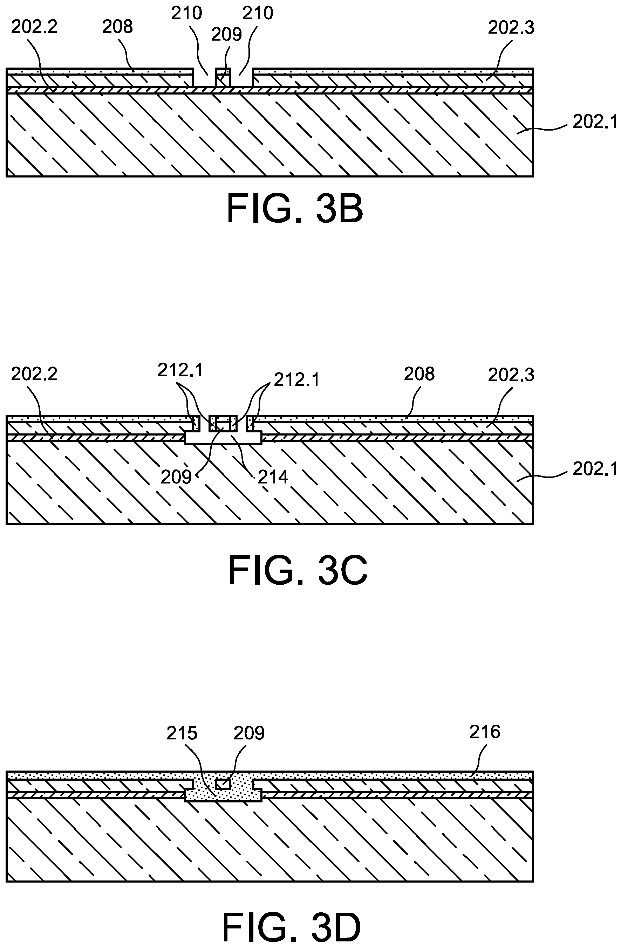

L'élément ainsi obtenu est représenté sur la figure 3B.

On effectue ensuite des étapes similaires à celles représentées sur les figures 1B et 1C, elles ne seront donc pas décrites en détail.

Lors d'une étape suivante, la première zone suspendue 209 est libérée par gravure isotrope de SiGe sélective par rapport au silicium et la couche de passivation 208.1 qui recouvre les bords latéraux de la première zone suspendue. Il s'agit d'une gravure avec arrêt au temps.

L'élément ainsi obtenu est représenté sur la figure 3C.

Une cavité 214 est alors formée sous et autour de la première zone suspendue.

Lors d'une étape suivante, on effectue un dépôt d'une couche d'arrêt 215 de gravure du silicium au moins dans le fond de la cavité 214.

Préalablement au dépôt de la couche d'arrêt 214, les portions de passivation 212.1 et la couche d'oxyde 8 sont de préférence retirées.

La couche d'arrêt 215 est formée de manière similaire à celle décrite en relation avec la figure 1E.

Une étape de planarisation de la couche d'oxyde 216 peut avoir lieu.

L'élément ainsi obtenu est représenté sur la figure 3D.

On effectue ensuite des étapes similaires à celles représentées sur les figures 1F et 1J, elles ne seront donc pas décrites en détail. En particulier le premier substrat 202 est scellé sur un deuxième substrat 218 en face avant, et des contacts électriques 220 sont formés en face arrière du premier substrat. Le substrat 202 peut être préalablement aminci.

Lors de l'étape suivante, ont lieu une lithographie et une gravure, du type gravure profonde par ions réactifs ou DRIE par exemple, du premier substrat 202 de sorte à dégager certaines zones de la couche sacrificielle 216 pour réaliser la deuxième zone suspendue 219, et à atteindre la couche d'arrêt 215 entre le fond de la cavité 214 et la première zone suspendue. L'épaisseur de la couche d'arrêt 215 est telle qu'elle protège la première zone suspendue 209 de la gravure profonde.

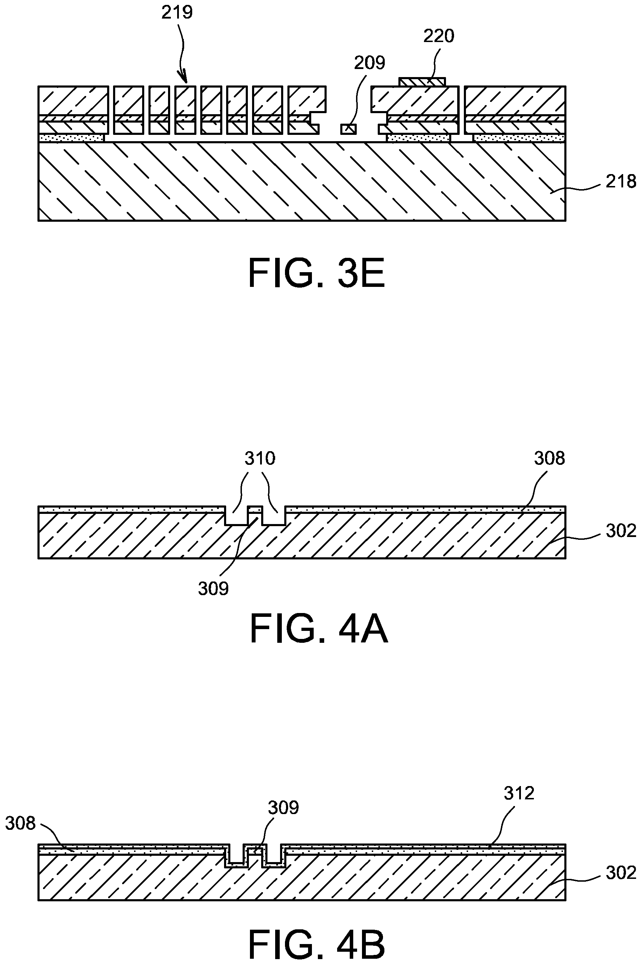

L'élément ainsi obtenu est représenté sur la figure 3E. La première zone suspendue 209 comporte alors une seule couche de semi-conducteur, et la deuxième zone suspendue 219 comporte trois couches, deux en silicium séparées par une couche de SiGe.

De manière avantageuse, les couches épitaxiées de SiGe et Si au niveau de la deuxième zone suspendue 219 peuvent être retirées, ce qui permet d'éviter les contraintes mécaniques dans les zones libérées dues à la présence du SiGe. Ce retrait peut être obtenu en procédant à une gravure de cet empilement préalablement à l'étape de dépôt de la couche sacrificielle 216 et l'étape de scellement avec le deuxième substrat.

Sur les figures 4A à 4E, on peut voir un exemple d'un procédé selon un deuxième mode de réalisation, qui diffère du premier mode de réalisation en ce que le matériau semi-conducteur sous le première zone suspendue est oxydé thermiquement et non plus retiré par gravure isotropique.

Le procédé selon le deuxième mode de réalisation comporte les étapes principales suivantes à partir d'un premier substrat silicium de type bulk :
a2) usinage de la face avant du premier substrat pour définir une première zone suspendue suivant une première épaisseur,
b2) formation d'une couche d'arrêt de la gravure de la première zone suspendue entre ladite zone suspendue et la face arrière obtenue par oxydation du matériau semi-conducteur disposé sous la première zone suspendue ;
c2) dépôt d'une couche sacrificielle sélective à la gravure par rapport au silicium, et plus généralement par rapport au matériau semi-conducteur du premier substrat ;
d2) usinage à partir de la face arrière du premier substrat jusqu'à dégager certaines zones de ladite couche sacrificielle pour réaliser au moins une deuxième zone suspendue et/ou pour permettre d'atteindre la couche d'arrêt de la première zone suspendue ;
e2) libération des première et deuxième zones suspendues.

De manière avantageuse, entre l'étape c2) et l'étape d2), on prévoit l'étape c2') le report ou le dépôt d'un support en face avant du premier substrat

Les différentes sous-étapes de l'étape a2) représentées sur les figures 4A à 4C sont similaires à celles représentées sur les figures 1A à 1C du premier mode de réalisation, et seront décrites succinctement.

Le premier substrat 302 recouvert d'une couche d'oxyde 308 est gravé de sorte à délimiter deux cavités 310 de part et d'autre de la première zone suspendue 309 (figure 4A).

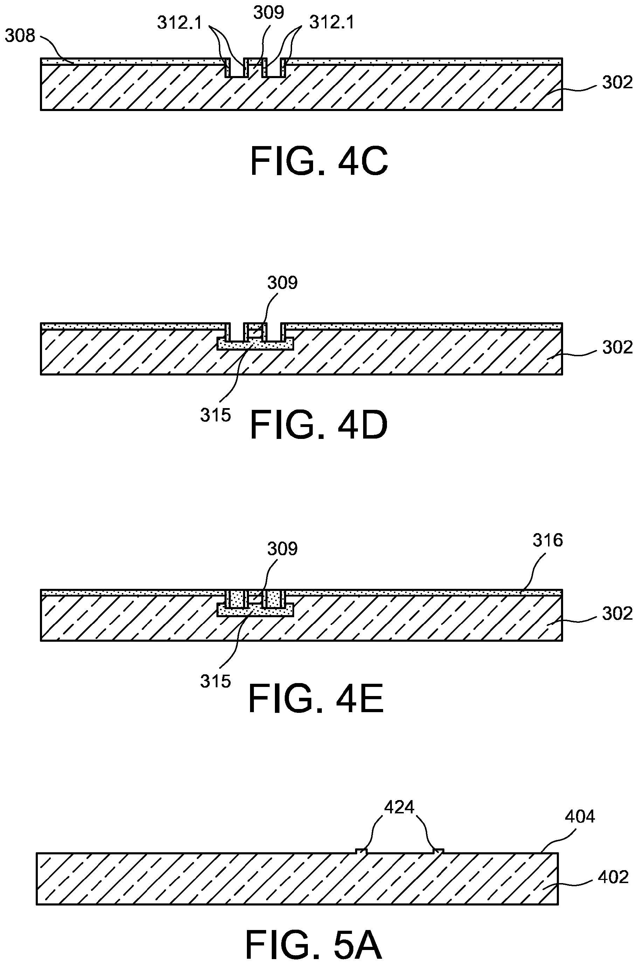

Une couche de passivation 312 est déposée (figure 4B) et gravé de sorte à ne laisser subsister que des portions de passivation 312.1 (figure 4C).

Lors d'une étape suivante b2), on réalise une oxydation thermique du silicium jusqu'à oxyder complètement la portion de silicium située au-dessous de la première zone suspendue 309. Par exemple, si la largeur de la zone à libérer est de 0,3 µm, on effectue une oxydation thermique supérieure à 0,15 µm, l'oxydation ayant lieu de part et d'autre 'autre de la portion à oxyder. La portion 315 située sous la première zone suspendue 309 forme la couche d'arrêt du premier mode de réalisation.

L'élément ainsi obtenu est représenté sur la figure 4D, la portion oxydée est désignée 315. La couche d'oxyde 308 et les portions de passivation 312.1 peuvent éventuellement être retirées.

Ensuite, on effectue un dépôt de SiO₂ afin de reboucher au moins en partie les cavités 310.

En outre, on forme également une couche sacrificielle 316 sur la face avant du premier substrat 302.

Une étape de planarisation et/ou d'amincissement, par exemple par planarisation mécano-chimique, de la couche d'oxyde 316 peut avoir lieu, par exemple pour obtenir une couche 316 dont l'épaisseur est comprise entre 0,5 µm et 1µm. Cette étape peut être requise lorsque les cavités 310 ont été entièrement rebouchées.

L'élément ainsi obtenu est représenté sur la figure 4E.

Les étapes suivantes sont similaires aux étapes représentées sur les figures 1F à 1J.

Le premier substrat 302 est scellé sur un second substrat 318 en face avant. Celui peut avoir préalablement été aminci.

Une lithographie et une gravure en face arrière du premier substrat ont lieu pour définir la deuxième zone suspendue, la gravure se fait avec arrêt sur l'oxyde.

Enfin les première et deuxième zones suspendues sont libérées, par exemple avec de l'acide fluorhydrique.

Sur les figures 5A à 5C, on peut voir une variante du procédé selon le premier ou le deuxième mode de réalisation, dans laquelle le premier substrat est usiné avant son scellement avec le deuxième substrat.

Dans l'exemple qui va être décrit, l'usinage du premier substrat a pour but de former des butées mécaniques. Les motifs usinés pourraient avoir une autre fonction.

Lors d'une étape préalable à l'étape a), on effectue une étape de lithographie sur la face avant 404 du premier substrat 402, pour délimiter les butées 424.

Ensuite, on grave la face avant 404 par exemple sur une profondeur de 0,3 µm. Enfin on retire la résine. La face avant comporte deux zones en saillie 424 formant des butées mécaniques destinées à coopérer avec le deuxième substrat.

L'élément ainsi obtenu est représenté sur la figure 5A.

Les étapes suivantes sont similaires à celles décrites précédemment.

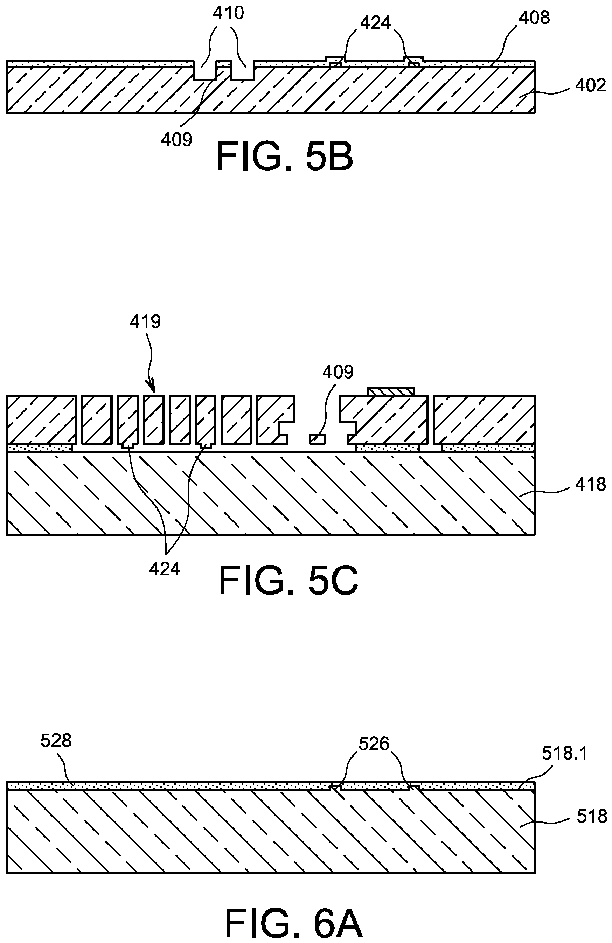

On peut voir sur la figure 5B, l'élément après gravure des cavités 410 de part et d'autre de la première zone suspendue 409.

Après dépôt de la couche sacrificielle, une étape de planarisation peut avoir lieu, dans ce cas celle-ci est telle qu'elle tient compte du dépassement des butées de la face avant.

Sur la figure 5C, on peut voir l'élément scellé sur le deuxième substrat 418 après libération des première 109 et deuxième 419 parties, les butées 424 font face à la face avant du deuxième substrat 418.

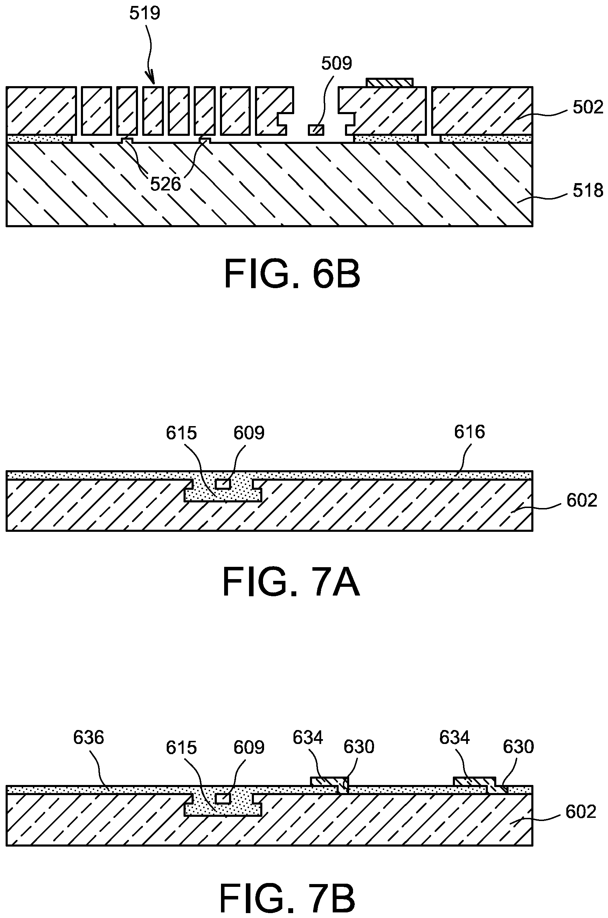

Sur les figures 6A et 6B, on peut voir une variante du procédé selon le premier ou deuxième mode de réalisation, dans laquelle le deuxième substrat est usiné avant son scellement sur le premier substrat.

Dans l'exemple qui va être décrit, l'usinage du deuxième substrat a également pour but de former des butées mécaniques. Les motifs usinés pourraient avoir une autre fonction.

L'étape de réalisation des butées 526 est très proche de celle des butées 524 sur le premier substrat.

Lors d'une étape préalable à l'étape de scellement au premier substrat 502, on effectue une étape de lithographie sur la face avant 518.1 du deuxième substrat 518, pour délimiter les butées 526.

Ensuite, on grave la face avant 518.1 par exemple sur une profondeur de 0,5 µm. Il s'agit par exemple d'une gravure au temps.

On effectue ensuite le dépôt d'une couche de scellement 528, par exemple en SiO₂, et une planarisation de celle-ci par exemple par polissage mécano-chimique (figure 6A).

Le premier substrat peut comporter une couche de scellement. En variante on peut effectuer un scellement direct Si/SiO₂ ou un scellement direct SiO_{2/}SiO₂.

Après scellement et gravure de la deuxième zone suspendue 519, on libère la première 509 et la deuxième 519 zone suspendue par exemple au moyen d'acide fluorhydrique. Cette libération voit le retrait d'une partie de la couche 528 située à l'interface entre les deux substrats et la mise au jour des butées 526.

Sur les figures 7A à 7C, on peut voir une autre variante d'un procédé de réalisation selon premier ou deuxième mode de réalisation, dans laquelle la couche sacrificielle déposée sur le premier substrat est structurée avant scellement et des couches intermédiaires sont déposées sur la couche sacrificielle structurée, avant scellement, et sont également structurées. Dans l'exemple représenté la structuration de la couche sacrificielle et de couches intermédiaires a pour objectif de former par exemple des butées de la deuxième zone suspendue vers le haut et vers le bas.

Les étapes représentées sur les figures 1A à 1E sont effectuées sur un substrat 602. On obtient l'élément de la figure 7A, comportant une première zone suspendue entourée 609, le premier substrat 602 étant recouvert d'une couche sacrificielle 616, une couche d'arrêt 615 ayant été formée sous la première zone suspendue 609.

Lors d'une étape suivante, on effectue sur la couche sacrificielle 616 une lithographie pour délimiter des zones d'ancrage 630 des butées sur le premier substrat 602 et une gravure de la couche sacrificielle 616 afin d'ouvrir les zones d'ancrage 630.

On effectue ensuite un dépôt d'une couche de silicium pour former les butées, par exemple sur une épaisseur de 0,4 µm.

Ensuite, afin de former les butées, on réalise une lithographie sur la couche de silicium et une gravure de celle-ci. Les butées 634 sont alors formées.

L'élément ainsi obtenu est représenté sur la figure 7B.

Lors d'une étape suivante, on effectue un dépôt de SiO₂ 636, sur les butées et une planarisation, par exemple par polissage mécano-chimique de sorte à obtenir une face avant plane destinée au scellement avec le deuxième substrat 618.

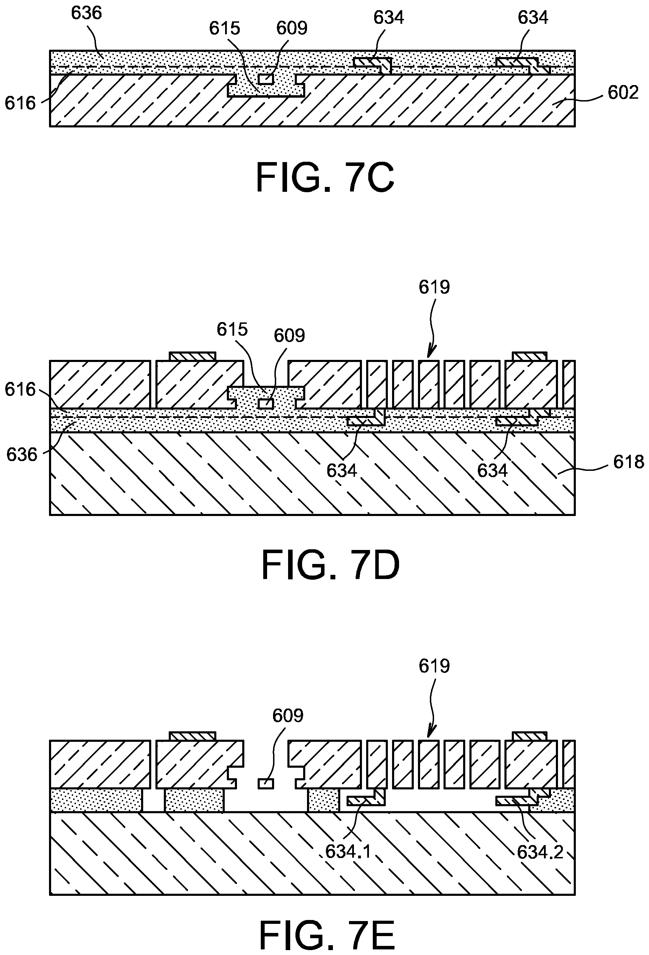

L'élément ainsi obtenu est représenté sur la figure 7C.

L'élément de la figure 7C subit ensuite des étapes similaires aux étapes représentées sur les figures 1F à 1I.

L'élément obtenu comporte le premier 602 et le deuxième 618 substrat scellés; le premier substrat 602 a été gravé par DRIE pour définir la deuxième zone suspendue 619 et atteindre la couche sacrificielle 616, et la couche d'arrêt 615. Les butées 634 sont situées entre le premier et le deuxième substrat à l'aplomb de la deuxième zone suspendue (figure 7D).

On effectue alors la libération des première 609 et deuxième 619 zone suspendues par exemple par acide fluorhydrique, ce qui a pour effet de découvrir les butées 434 (figure 7E).

L'étape de gravure de la deuxième structure est telle que l'une des butées 634.1 est solidaire de la deuxième zone suspendue mobile et la butée 634.2 est solidaire de la partie fixe de la structure. La butée 634.1 forme alors une butée vers le haut pour la deuxième zone suspendue mobile et la butée 634.2 forme une butée vers le bas pour la deuxième zone suspendue mobile.

Une telle structuration préalable n'est pas limitée à la réalisation de butées mais peut permettre de fabriquer des circuits CMOS, de réaliser un substrat muni d'électrodes par exemple d'excitation de la ou des parties actives, de détection, d'actionnement, pour former un routage électrique, pour former un plan de masse relié à la couche MEMS, former une ou plusieurs cavités, pour réaliser des butées anti-collage ...

On peut prévoir alternativement soit de ne faire qu'une structuration de la couche sacrificielle, les couches intermédiaires n'étant pas structurées, soit de déposer des couches intermédiaires sur une couche sacrificielle non structurée.

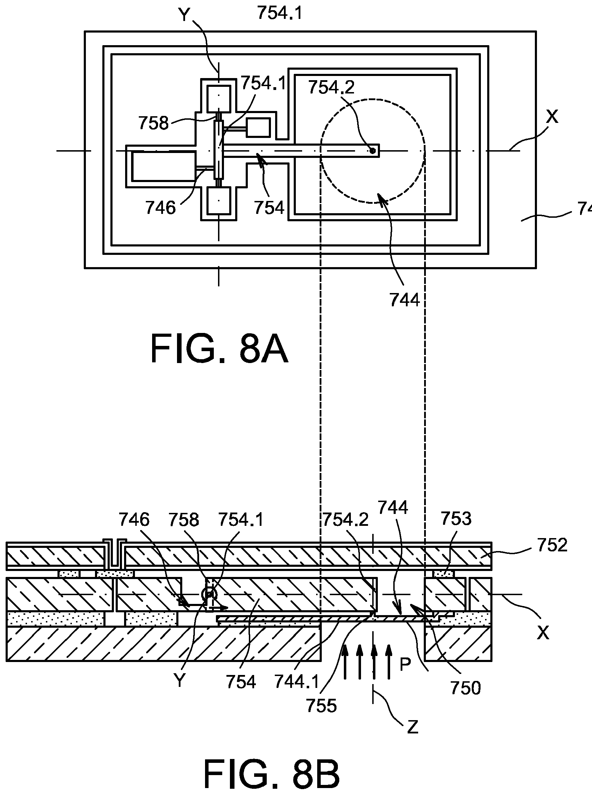

Sur les figures 8A et 8B, on peut voir des vues de dessus et en coupe, respectivement d'un exemple de réalisation d'un capteur de pression qui peut être réalisé grâce au procédé selon l'invention avec structuration de la couche sacrificielle et d'une couche intermédiaire en silicium polycristallin. Sur la figure 8B, le capteur comporte un capot, alors que la figure 8A, celui-ci a été retiré.

Le capteur comporte un substrat 742, une membrane 744 suspendue sur le substrat 742, la membrane étant telle qu'elle se déforme sous l'action d'une différence de pression sur ses deux faces, des moyens de détection 746 de la déformation de la membrane 744 située sur le substrat et des moyens aptes à transmettre la déformation de la membrane 744 aux moyens de détection 746.

La membrane 744 est soumise sur une de ses faces 744.1 à la pression P que l'on souhaite mesurer, dans la représentation de la figure 8B, il s'agit de la face inférieure de la membrane. L'autre face 744.2 est soumise à une pression de référence qui est réalisée dans une cavité 750 formée entre la membrane 744 et un capot 752. Dans le cas d'un capteur de pression absolue, le vide est réalisé dans la cavité 750. Le capot 752 est scellé sur le substrat 742 soit au moyen d'un cordon de scellement 753 ou par scellement direct, du type sans cordon.

Dans l'exemple représenté, la membrane 744 a la forme d'un disque (en pointillés sur la figure 8A) mais elle pourrait présenter toute autre forme, comme une forme carrée, hexagonale....

Les moyens pour transmettre la déformation de la membrane 744 aux moyens de détection 746 sont formés par un bras 754 d'axe longitudinal X, monté mobile en rotation par rapport au substrat au niveau d'une première extrémité longitudinale 754.1, l'axe de rotation Y est sensiblement parallèle à la membrane et au plan du substrat. En outre, le bras 754 est rendu solidaire en mouvement de la membrane au niveau de sa deuxième extrémité longitudinale 754.2.

Cette liaison peut être pourvue d'une articulation souple 755, de type ressort, qui permet de transmettre entièrement l'effort en Z induit par la déformation de la membrane, tout en limitant l'effort parasite en X, i.e. suivant l'axe du bras 754 dû à cette déformation.

Le bras a, dans l'exemple représenté, la forme d'une poutre rigide à section rectangulaire. La poutre pourrait en variante avoir une forme trapézoïdale.

De préférence, la deuxième extrémité longitudinale 754.2 du bras 754 est solidaire de la membrane au niveau ou proche de la zone présentant la déformation maximale. Le déplacement du bras autour de son axe de rotation Y vu par les moyens de détection est alors maximal et la sensibilité du capteur est alors optimisée.

Les moyens de détection 746 sont disposés sur le substrat de sorte qu'ils détectent le déplacement de la première extrémité longitudinale 754.1 du bras, ce déplacement étant proportionnel à l'amplitude de déformation de la membrane 744. Le bras 754 formant un bras de levier, la contrainte vue par les moyens de détection 746 est amplifiée par rapport à la déformation de la membrane. Dans le cas d'une mesure par jauge, le bras de levier augmente la contrainte exercée sur les jauges mais diminue l'amplitude de déformation par rapport à l'amplitude de déformation de la membrane du fait de la loi de conservation des moments.

Dans l'exemple représenté sur la figure 8A, la liaison pivot d'axe Y est formée par une poutre 758 d'axe Y sollicitée en torsion autour de l'axe Y. La poutre est ancrée au niveau de chacune de ses extrémités sur le substrat. Dans la suite de la description, la poutre 758 sera désignée "axe de torsion". Avantageusement, cette poutre 758 comprend une partie rigide en flexion suivant l'axe X pour transmettre toute la contrainte sur laquelle sont fixées les jauges, et une partie formant axe de torsion à ses extrémités également rigide en flexion suivant l'axe X de la contrainte.

D'après le procédé de réalisation, la membrane 744 et le routage électrique sont réalisés par la couche intermédiaire de silicium polycristallin décrite en relation avec la figure 7B. Les jauges de contrainte correspondent aux premières zones ou parties NEMS, et le bras de levier correspond à la deuxième zone suspendue ou partie MEMS.

Il a été décrit la possibilité d'amincir le premier substrat après scellement avec le deuxième substrat. Alternativement, on peut également amincir le premier et le deuxième substrat après scellement ou uniquement le deuxième substrat.

Il est envisageable de réaliser une partie active avec plus de deux épaisseurs différentes, en répétant les étapes a) et b).

Les variantes du procédé selon le premier ou deuxième mode de réalisation selon l'invention ne sont pas exclusives les unes des autres et peuvent être combinées.

Il est aussi possible de réaliser une co-intégration CMOS en trois dimensions. Dans ce cas, on remplace le deuxième substrat par un substrat CMOS. La récupération des contacts peut se faire soit par des vias ou TSV (Through-silcon via en terminologie anglo-saxonne), soit lors du scellement, par un eutectique dans ce cas, type AlGe par exemple, qui sont des techniques bien connues de l'homme du métier.

Le procédé selon l'invention est particulièrement adapté à la réalisation de capteurs et d'actionneurs microélectromécaniques et/ou de systèmes nanoélectromécaniques.

## Revendications

1. Procédé de réalisation d'une structure comportant une partie active comprenant au moins une première zone suspendue (9, 109, 209, 309, 409, 509, 609) et une deuxième zone suspendue (19, 119, 219, 319, 419, 519, 619) d'épaisseurs différentes à partir d'un premier substrat (2, 102, 202, 302, 402, 502, 602), ledit premier substrat comportant une première face en matériau semi-conducteur monocristallin, dite face avant, et une deuxième face opposée à la première face, dite face arrière, ledit procédé comportant les étapes :
a) usinage de la face avant du premier substrat (2, 102, 202, 302, 402, 502, 602) pour définir les contours latéraux (12.1) d'au moins une première zone suspendue (9, 109, 209, 309, 409, 509, 609) en matériau semi-conducteur monocristallin suivant une première épaisseur inférieure à celle du premier substrat, et passivation desdits contours latéraux (121)
b) formation d'une couche d'arrêt (15, 115, 215, 315, 415, 515, 615) de gravure de la première zone suspendue (9, 109, 209, 309, 409, 509, 609) entre ladite première zone suspendue (9, 109, 209, 309, 409, 509, 609) et la face arrière ;
c) formation sur la face avant du premier substrat d'une couche sacrificielle (16, 116, 216, 316, 416, 516, 616) sélective à la gravure par rapport au matériau semi-conducteur du premier substrat ;
d) usinage à partir de la face arrière du premier substrat (2, 102, 202, 302, 402, 502, 602) jusqu'à dégager certaines zones de ladite couche sacrificielle (16, 116, 216, 316, 416, 516, 616) pour réaliser au moins une deuxième zone suspendue (19, 119, 219, 319, 419, 519, 619) et pour permettre d'atteindre la couche d'arrêt (15, 115, 215, 315, 415, 515, 615) de la première zone suspendue (9, 109, 209, 309, 409, 509, 609),
e) libération des première (9, 109, 209, 309, 409, 509, 609) et deuxième (19, 119, 219, 319, 419, 519, 619) zones suspendues.

2. Procédé de réalisation selon la revendication 1, dans lequel la passivation des contours latéraux comporte un dépôt d'une couche de passivation sur lesdits contours ou une oxydation thermique desdits contours.

3. Procédé de réalisation selon la revendication 1 ou 2, dans lequel, la face arrière du premier substrat étant matériau semi-conducteur monocristallin, la deuxième zone suspendue est en matériau semi-conducteur monocristallin.

4. Procédé de réalisation selon l'une des revendications 1 à 3, dans lequel lors de l'étape b), la couche d'arrêt (315) est formée par oxydation thermique pour transformer une portion de matériau semi-conducteur située entre la première zone suspendue (309) et la face arrière, de sorte à former ladite couche d'arrêt (315).

5. Procédé de réalisation selon l'une des revendications 1, 2 ou 3, dans lequel entre l'étape a) et l'étape b), une étape de gravure isotropique a lieu pour retirer une portion de matériau semi-conducteur située entre la première zone suspendue (9, 109, 209) et la face arrière, de sorte à dégager une cavité (14, 114, 214) destinée à recevoir la couche d'arrêt (15, 115, 215).

6. Procédé de réalisation selon l'une des revendications 1 à 5, dans lequel la couche d'arrêt est formée par une oxydation thermique, et/ou un dépôt d'oxyde.

7. Procédé de réalisation selon l'une des revendications 1 à 6, dans lequel la formation de la couche sacrificielle (16, 116, 216, 316, 416, 516, 616) est réalisée par un dépôt d'oxyde.

8. Procédé de réalisation selon la revendication 7 en combinaison avec la revendication 6, dans lequel l'étape b) et l'étape c) sont confondues.

9. Procédé de réalisation selon l'une des revendications 1 à 8, dans lequel le premier substrat (102, 202) comporte un empilement d'une couche de SiGe monocristallin recouverte d'un couche de silicium monocristallin, la face avant étant en silicium monocristallin et l'étape a) étant telle que la première zone suspendue (116, 216) comporte une couche de silicium monocristallin et une couche de SiGe monocristallin.

10. Procédé de réalisation selon la revendication 9 en combinaison avec la revendication 5, dans lequel préalablement à l'étape b), au moins la couche de SiGe de la zone suspendue est retirée.

11. Procédé de réalisation selon l'une des revendications 1 à 10, dans lequel le procédé comporte, en entre l'étape c) et avant l'étape d), une étape c') de scellement ou de dépôt d'un deuxième substrat (18, 118, 218, 318, 418, 518, 618) en face avant du premier substrat (2, 102, 202, 302, 402, 502, 602).

12. Procédé de réalisation selon la revendication 11, dans lequel le procédé comporte, préalablement à l'étape c'), une étape de structuration du deuxième substrat (518).

13. Procédé de réalisation selon la revendication 12, dans lequel, lors de l'étape de structuration, une face avant (518.1) du deuxième substrat (518) est gravée de sorte à réaliser des motifs (526) pour la deuxième zone suspendue (519) et un dépôt est effectué sur ladite face structurée d'une couche destinée à former une couche de scellement lors de l'étape de scellement du deuxième substrat (618).

14. Procédé de réalisation selon l'une des revendications 1 à 13, dans lequel le procédé comporte, suite à l'étape c), l'étape de structuration de la couche sacrificielle (616) et/ou de dépôt de une ou plusieurs couches intermédiaires sur ladite couche sacrificielle (616), lesdites couches intermédiaires pouvant être structurées.

15. Procédé de réalisation selon la revendication 14, dans lequel le procédé comporte une étape de dépôt d'une couche de d'oxyde sur la couche sacrificielle structurée et/ou la ou les couches intermédiaires et une étape de planarisation de la couche d'oxyde, ladite couche d'oxyde participant au scellement.

16. Procédé de réalisation selon l'une des revendications 1 à 15, dans lequel le premier substrat (402) est structuré avant l'étape a).

17. Procédé de réalisation selon l'une des revendications 1 à 16, dans lequel l'étape d) d'usinage pour permettre de réaliser la deuxième zone suspendue et pour d'usinage pour atteindre la couche d'arrêt est obtenue par usinage simultané ou par usinages successifs.

18. Procédé de réalisation selon l'une des revendications 1 à 17, dans lequel les étapes a) à b) sont répétées afin de réaliser une partie active ayant plus de deux couches.

19. Procédé de réalisation selon l'une des revendications 1 à 18, dans lequel le matériau semi-conducteur de la face avant du premier substrat est du silicium monocristallin.

20. Procédé de réalisation selon l'une des revendications 1 à 19, de structures microélectromécaniques et/ou nanoélectromécaniques pour réaliser des capteurs et/ou des actionneurs.

21. Procédé selon la revendication 20, dans lequel le capteur est un capteur de pression comportant au moins une membrane (44) déformable suspendue sur un substrat (742), une des faces de la membrane étant destinée à être soumise à la pression à mesurer, des moyens de détection (46) de la déformation de la membrane (44) formés par au moins une jauge de contraintes, la ou lesdites jauges étant formées par la ou les premières zones suspendues, lesdits moyens de détection (46) étant réalisés à partir du substrat (742) et des moyens de transmission (54) de la déformation de la membrane (44), aux moyens de détection (46), lesdits moyens de transmission (54) comportant un bras longitudinal articulé en rotation sur le substrat (742) autour d'un axe (Y) sensiblement parallèle au plan de la membrane (44) et étant solidaires, au moins partiellement de la membrane (44) de sorte qu'il transmette aux moyens de détection (46), de manière amplifiée, la déformation ou la contrainte issue de la déformation de la membrane (44), ledit bras longitudinal étant formé par la deuxième zone suspendue, lesdits moyens de transmission étant réalisés à partir du substrat.

## Patentansprüche

1. Verfahren zum Herstellen einer Struktur mit einem Wirkteil, der zumindest einen ersten abgehängten Bereich (9, 109, 209, 309, 409, 509, 609) und einen zweiten abgehängten Bereich (19, 119, 219, 319, 419, 519, 619) enthält, die unterschiedliche Materialstärken haben, ausgehend von einem ersten Substrat (2, 102, 202, 302, 402, 502, 602), wobei das erste Substrat eine erste Seite aus monokristallinem Halbleitermaterial, Vorderseite genannt, und eine der ersten Seite entgegengesetzte zweite Seite, Hinterseite genannt, aufweist, wobei das Verfahren die nachfolgenden Schritte umfasst:
a) Bearbeiten der Vorderseite des ersten Substrats (2, 102, 202, 302, 402, 502, 602), um Seitenkonturen (12.1) von zumindest einem ersten abgehängten Bereich (9, 109, 209, 309, 409, 509, 609) aus monokristallinem Halbleitermaterial in einer ersten Materialstärke zu definieren, die geringer als die des ersten Substrats ist, und Passivierung der Seitenkonturen (121),
b) Ausbilden einer Sperrschicht (15, 115, 215, 315, 415, 515, 615) durch Ätzen des ersten abgehängten Bereichs (9, 109, 209, 309, 409, 509, 609) zwischen dem ersten abgehängten Bereich (9, 109, 209, 309, 409, 509, 609) und der Hinterseite;
c) Bilden einer selektiven Opferschicht (16, 116, 216, 316, 416, 516, 616) auf der Vorderseite des ersten Substrats beim Ätzen bezüglich des Halbleitermaterials des ersten Substrats;
d) Bearbeiten ausgehend von der Hinterseite des ersten Substrats (2, 102, 202, 302, 402, 502, 602) bis zum Freilegen bestimmter Bereiche der Opferschicht (16, 116, 216, 316, 416, 516, 616), um zumindest einen zweiten abgehängten Bereich (19, 119, 219, 319, 419, 519, 619) auszubilden und um zu gestatten, die Sperrschicht (15, 115, 215, 315, 415, 515, 615) des ersten abgehängten Bereichs (9, 109, 209, 309, 409, 509, 609) zu erreichen,
e) Freigeben des ersten (9, 109, 209, 309, 409, 509, 609) und des zweiten abgehängten Bereichs (19, 119, 219, 319, 419, 519, 619).

2. Herstellungsverfahren nach Anspruch 1, wobei die Passivierung der Seitenkonturen ein Aufbringen einer Passivierungsschicht auf die Konturen bzw. eine thermische Oxidation der Konturen umfasst.

3. Herstellungsverfahren nach Anspruch 1 oder 2, wobei bei einer aus monokristallinem Halbleitermaterial bestehenden Hinterseite des ersten Substrats der zweite abgehängte Bereich aus monokristallinem Halbleitermaterial besteht.

4. Herstellungsverfahren nach einem der Ansprüche 1 bis 3, wobei in Schritt b) die Sperrschicht (315) durch thermische Oxidation gebildet ist, um einen Halbleitermaterial-Abschnitt umzuwandeln, der zwischen dem ersten abgehängten Bereich (309) und der Hinterseite liegt, so dass die Sperrschicht (315) gebildet wird.

5. Herstellungsverfahren nach einem der Ansprüche 1, 2 oder 3, wobei zwischen Schritt a) und Schritt b) ein Schritt des isotropen Ätzens erfolgt, um einen Halbleitermaterialabschnitt zu entfernen, der zwischen dem ersten abgehängten Bereich (9, 109, 209) und der Hinterseite liegt, so dass ein Hohlraum (14, 114, 214) freigelegt wird, der dazu bestimmt ist, die Sperrschicht (15, 115, 215) aufzunehmen.

6. Herstellungsverfahren nach einem der Ansprüche 1 bis 5, wobei die Sperrschicht durch thermische Oxidation und/oder durch Oxidablagerung ausgebildet ist.

7. Herstellungsverfahren nach einem der Ansprüche 1 bis 6, wobei das Ausbilden der Opferschicht (16, 116, 216, 316, 416, 516, 616) durch Oxidablagerung erfolgt.

8. Herstellungsverfahren nach Anspruch 7 in Kombination mit Anspruch 6, wobei Schritt b) und Schritt c) zusammenfallen.

9. Herstellungsverfahren nach einem der Ansprüche 1 bis 8, wobei das erste Substrat (102, 202) eine Stapelung einer monokristallinen SiGe-Schicht enthält, die mit einer monokristallinen Siliciumschicht überzogen ist, wobei die Vorderseite aus monokristallinem Silicium besteht und Schritt a) derart ist, dass der erste abgehängte Bereich (116, 216) eine monokristalline SiliciumSchicht und eine monokristalline SiGe-Schicht enthält.

10. Herstellungsverfahren nach Anspruch 9 in Kombination mit Anspruch 5, wobei vor Schritt b) zumindest die SiGe-Schicht des abgehängten Bereichs entfernt wird.

11. Herstellungsverfahren nach einem der Ansprüche 1 bis 10, wobei das Verfahren zwischen Schritt c) und vor Schritt d) einen Schritt c') zum Versiegeln oder Aufbringen eines zweiten Substrats (18, 118, 218, 318, 418, 518, 618) auf der Vorderseite des ersten Substrats (2, 102, 202, 302, 402, 502, 602) umfasst.

12. Herstellungsverfahren nach Anspruch 11, wobei das Verfahren vor Schritt c') einen Schritt des Strukturierens des zweiten Substrats (518) umfasst.

13. Herstellungsverfahren nach Anspruch 12, wobei beim Schritt des Strukturierens eine Vorderseite (518.1) des zweiten Substrats (518) so geätzt wird, dass Muster (526) für den zweiten abgehängten Bereich (519) gebildet werden und ein Aufbringen einer Schicht auf die strukturierte Seite erfolgt, die dazu bestimmt ist, eine Versiegelungsschicht beim Schritt des Versigelns des zweiten Substrats (618) zu bilden.

14. Herstellungsverfahren nach einem der Ansprüche 1 bis 13, wobei das Verfahren nach Schritt c) den Schritt des Strukturierens der Opferschicht (616) und/oder des Aufbringens einer oder mehrerer Zwischenschichten auf die Opferschicht (616) umfasst, wobei die Zwischenschichten strukturiert sein können.

15. Herstellungsverfahren nach Anspruch 14, wobei das Verfahren einen Schritt des Aufbringens einer Oxidschicht auf die strukturierte Opferschicht und/oder auf die Zwischenschicht bzw. Zwischenschichten und einen Schritt des Planarisierens der Oxidschicht umfasst, wobei die Oxidschicht zur Versiegelung beiträgt.

16. Herstellungsverfahren nach einem der Ansprüche 1 bis 15, wobei das erste Substrat (402) vor dem Schritt a) strukturiert wird.

17. Herstellungsverfahren nach einem der Ansprüche 1 bis 16, wobei der Schritt d) der Bearbeitung zum Ausbilden des zweiten abgehängten Bereichs und der Bearbeitung zum Erreichen der Sperrschicht durch gleichzeitige Bearbeitung oder aufeinanderfolgende Bearbeitungen erfolgt.

18. Herstellungsverfahren nach einem der Ansprüche 1 bis 17, wobei die Schritte a) bis b) wiederholt werden, um einen Wirkteil mit mehr als zwei Schichten auszubilden.

19. Herstellungsverfahren nach einem der Ansprüche 1 bis 18, wobei das Halbleitermaterial der Vorderseite des ersten Substrats aus monokristallinem Silicium besteht.

20. Herstellungsverfahren nach einem der Ansprüche 1 bis 19 zum Herstellen von mikroelektromechanischen und/oder nanoelektromechanischen Strukturen zum Ausbilden von Sensoren und/oder Aktuatoren.

21. Verfahren nach Anspruch 20, wobei der Sensor ein Drucksensor ist, der zumindest eine verformbare Membran (44) enthält, die an einem Substrat (742) abhängt ist, wobei eine der Seiten der Membran dazu bestimmt ist, dem zu messenden Druck ausgesetzt zu werden, sowie Detektionsmittel (46) zum Detektieren der Verformung der Membran (44), die aus zumindest einer Dehnungsmesseinrichtung gebildet sind, wobei die Dehnungsmesseinrichtung bzw. Dehnungsmesseinrichtungen aus dem bzw. den ersten abgehängten Bereichen gebildet sind, wobei die Detektionsmittel (46) ausgehend von dem Substrat (742) ausgebildet sind, und Übertragungsmittel (54) zum Übertragen der Verformung von der Membran (44) auf die Detektionsmittel (46), wobei die Übertragungsmittel (54) einen Längslenker enthalten, der um eine im Wesentlichen parallel zur Ebene der Membran (44) verlaufende Achse (Y) drehbar am Substrat (742) angelenkt ist, und zumindest teilweise mit der Membran (44) fest verbunden sind, so dass er die Verformung bzw. die von der Verformung der Membran (44) herrührende Spannung in verstärkter Weise auf die Detektionsmittel (46) übertragt, wobei der Längslenker aus dem zweiten aufgehängten Bereich gebildet ist, wobei die Übertragungsmittel ausgehend von dem Substrat ausgebildet sind.

## Claims

1. Method for producing a structure comprising an active part comprising at least one first suspended zone (9, 109, 209, 309, 409, 509, 609) and a second suspended zone (19, 119, 219, 319, 419, 519, 619) of different thicknesses from a first substrate (2, 102, 202, 302, 402, 502, 602), said first substrate comprising a first face made of monocrystalline semi-conductor material, called front face, and a second face opposite to the first face, called rear face, said method comprising the following steps:
a) machining the front face of the first substrate (2, 102, 202, 302, 402, 502, 602) to define the lateral contours (12.1) of at least one first suspended zone (9, 109, 209, 309, 409, 509, 609) made of monocrystalline semi-conductor material according to a first thickness less than that of the first substrate, and passivating said lateral contours (121);
b) forming a stop layer (15, 115, 215, 315, 415, 515, 615) of etching of the first suspended zone (9, 109, 209, 309, 409, 509, 609) between said first suspended zone (9, 109, 209, 309, 409, 509, 609) and the rear face;
c) forming on the front face of the first substrate a sacrificial layer (16, 116, 216, 316, 416, 516, 616) selective to the etching with respect to the semi-conductor material of the first substrate;
d) machining from the rear face of the first substrate (2, 102, 202, 302, 402, 502, 602) up to releasing certain zones of said sacrificial layer (16, 116, 216, 316, 416, 516, 616) to form at least one second suspended zone (19, 119, 219, 319, 419, 519, 619) and to make it possible to reach the stop layer (15, 115, 215, 315, 415, 515, 615) of the first suspended zone (9, 109, 209, 309, 409, 509, 609);
e) releasing the first (9, 109, 209, 309, 409, 509, 609) and second (19, 119, 219, 319, 419, 519, 619) suspended zones.

2. Production method according to claim 1, wherein the passivation of the lateral contours comprises a deposition of a passivation layer on said contours or a thermal oxidation of said contours.

3. Production method according to claim 1 or 2, wherein, the rear face of the first substrate being monocrystalline semi-conductor material, the second suspended zone is made of monocrystalline semi-conductor material.

4. Production method according to one of claims 1 to 3, wherein during step b), the stop layer (315) is formed by thermal oxidation to transform a portion of semi-conductor material situated between the first suspended zone (309) and the rear face, so as to form said stop layer (315).

5. Production method according to one of claims 1, 2 or 3, wherein between step a) and step b), a step of isotropic etching takes place to remove a portion of semi-conductor material situated between the first suspended zone (9, 109, 209) and the rear face, so as to release a cavity (14, 114, 214) intended to receive the stop layer (15, 115, 215).

6. Production method according to one of claims 1 to 5, wherein the stop layer is formed by thermal oxidation, and/or deposition of oxide.

7. Production method according to one of claims 1 to 7, wherein the formation of the sacrificial layer (16, 116, 216, 316, 416, 516, 616) is carried out by deposition of oxide.

8. Production method according to claim7 in combination with claim 6, wherein the stop layer is formed by thermal oxidation, and/or deposition of oxide and wherein step b) and step c) are merged.

9. Production method according to one of claims 1 to 8, wherein the first substrate (102, 202) comprises a stacking of a layer of monocrystalline SiGe covered with a layer of monocrystalline silicon, the front face being made of monocrystalline silicon and step a) being such that the first suspended zone (116, 216) comprises a layer of monocrystalline silicon and a layer of monocrystalline SiGe.

10. Production method according to claim 9 in combination with claim 5, wherein prior to step b), at least the SiGe layer of said suspended zone is removed.

11. Production method according to one of claims 1 to 10, wherein the method comprises, in between step c) and before step d), a step c') of bonding or depositing a second substrate (18, 118, 218, 318, 418, 518, 618) on the front face of the first substrate (2, 102, 202, 302, 402, 502, 602).

12. Production method according to claim 11, wherein the method comprises, prior to step c'), a step of structuring the second substrate (518).

13. Production method according to claim 12, wherein, during the structuring step, a front face (518.1) of the second substrate (518) is etched so as to form patterns (526) for the second suspended zone (519) and a deposition is carried out on said structured face of a layer intended to form a bonding layer during the step of bonding of the second substrate (618).

14. Production method according to claim 1 to 13, wherein the method comprises, following step c), the step of structuring the sacrificial layer (616) and/or depositing one or more intermediate layers on said sacrificial layer (616), said intermediate layers being able to be structured.

15. Production method according to claim 14, wherein the method comprises a step of depositing an oxide layer on the structured sacrificial layer and/or the intermediate layers(s) and a step of planarisation of the oxide layer, said oxide layer participating in the bonding.

16. Production method according to one of claims 1 to 15, wherein the first substrate (402) is structured before step a).

17. Production method according to one of claims 1 to 16, wherein step d) of machining to make it possible to form the second suspended zone and for machining to reach the stop layer is obtained by simultaneous machining or by successive machinings.

18. Production method according to one of claims 1 to 17, wherein steps a) to b) are repeated in order to form an active part having more than two layers.

19. Production method according to one of claims 1 to 18, wherein the semi-conductor material of the front face of the first substrate is monocrystalline silicon.

20. Production method, according to one of claims 1 to 19, of microelectromechanical and/or nanoelectromecanical structures for producing sensors and/or actuators.

21. Method according to claim 20, wherein the sensor is a pressure sensor comprising at least one deformable membrane (44) suspended on a substrate (742), one of the faces of the membrane being intended to be subjected to the pressure to be measured, means of detection (46) of the deformation of the membrane (44) formed by at least one strain gauge, said gauge(s) being formed by the first suspended zone(s), said means of detection (46) being formed from the substrate (742) and means of transmission (54) of the deformation of the membrane (44), to the means of detection (46), said means of transmission (54) comprising a longitudinal arm articulated in rotation on the substrate (742) around an axis (Y) substantially parallel to the plane of the membrane (44) and being integral, at least partially, with the membrane (44) such that it transmits to the means of detection (46), in an amplified manner, the deformation or the strain from the deformation of the membrane (44), said longitudinal arm being formed by the second suspended zone, said means of transmission being formed from the substrate.
